# FASCICULE DE BREVET EUROPEEN

(11) **EP 2 888 551 B1**
(45) Date de publication et mention de la délivrance du brevet: **17.10.2018**
(21) Numéro de dépôt: 13759989.0
(22) Date de dépôt: 16.08.2013
(51) Int. Cl.: G01B 11/00, B24B 49/12, G01B 11/06, G01N 21/95, H01L 21/66, H01L 21/67

(54) **DISPOSITIF ET PROCEDE POUR FAIRE DES MESURES DIMENSIONNELLES SUR DES OBJETS MULTI-COUCHES TELS QUE DES WAFERS**
VORRICHTUNG UND METHODE FÜR DIMENSIONSMESSUNGEN AN VIELSCHICHT-OBJEKTEN WIE WAFERN
DEVICE AND METHOD FOR DIMENSIONAL MEASUREMENTS ON MULTILAYER OBJECTS LIKE WAFERS

(30) Priorité: 21.08.2012 FR 1257906
(43) Date de publication de la demande: 01.07.2015
(73) Titulaire: Unity Semiconductor, 38330 Montbonnot-Saint-Martin (FR)
(72) Inventeur: FRESQUET, Gilles, F-30190 Garrigues Sainte Eulalie (FR); PERROT, Sylvain, F-91120 Palaiseau (FR)
(74) Mandataire: IPAZ
(86) Numéro de dépôt international: PCT/EP2013/067170
(87) Numéro de publication internationale: WO 2014/029703

(56) Documents cités:
- FR-A1- 2 959 305
- US-A- 5 821 549
- US-A1- 2005 231 713
- US-A1- 2012 122 252
- PERROT S ET AL: "A versatile optical system for metrology and defects inspection of 3D integration processes", LOW TEMPERATURE BONDING FOR 3D INTEGRATION (LTB-3D), 2012 3RD IEEE INTERNATIONAL WORKSHOP ON, IEEE, 22 mai 2012 (2012-05-22), page 191, XP032200385, DOI: 10.1109/LTB-3D.2012.6238088 ISBN: 978-1-4673-0743-7

## Description

### Domaine technique

La présente invention concerne un dispositif et procédé pour faire des mesures dimensionnelles sur des objets multi-couches tels que des wafers. Elle concerne également un dispositif d'imagerie permettant de localiser des structures sous la surface de tels objets, dans le but notamment de positionner des capteurs de mesure par rapport à ces structures.

Le domaine de l'invention est plus particulièrement mais de manière non limitative celui de la mesure et du contrôle dimensionnel des dispositifs dans le domaine de la microélectronique, des microsystèmes (MEMs) ou en optique intégrée.

### Etat de la technique antérieure

Les techniques de fabrication en microélectronique et dans les microsystèmes (MEMs, MOEMs) évoluent vers la réalisation de structures volumiques complexes, aptes à permettre une meilleure intégration en volume des fonctions de ces systèmes.

Ces structures se caractérisent par la superposition d'un nombre parfois important de couches de composants, avec des pistes d'interconnexion (ou vias) qui relient ces couches de composants. Ces techniques relèvent de ce qui est fréquemment appelé le « chip level packaging » ou « intégration 3D ».

Les couches de composants peuvent être réalisées sur des wafers distincts, qui sont ensuite superposés et interconnectés.

Plus précisément, les procédés de fabrication peuvent comprendre les étapes suivantes :
- gravure des vias, qui se présentent comme des trous ou des tranchées débouchant d'un seul côté du wafer (la face des composants) ;
- métallisation des vias et réalisation au moins partielle des pistes conductrices et des composants sur la face des composants,
- amincissement du wafer par polissage (usuellement par un procédé mécanique) de la face arrière (c'est-à-dire la face opposée à la face des composants). Le wafer est collé sur un wafer de transport temporaire afin d'obtenir une rigidité mécanique suffisante. En effet, après polissage l'épaisseur du wafer peut être réduite à quelques dizaines de micromètres.

L'amincissement permet de réduire l'épaisseur du wafer jusqu'à une épaisseur prédéterminée, ou jusqu'à ce que les vias deviennent traversant.

Il est très important de maîtriser l'épaisseur de matière résiduelle entre le fond des vias et la face arrière du wafer au cours de l'opération d'amincissement.

On connaît différentes techniques qui permettent de mesurer cette épaisseur de matière résiduelle.

On connaît par exemple les techniques basées sur l'interférométrie à faible cohérence, dans le domaine temporel ou dans le domaine spectral.

On connaît également le document US 7,738,113 de Marx et al. qui décrit un dispositif permettant d'effectuer cette mesure avec des sondes basées sur une technique confocale à balayage ou confocale à dispersion chromatique.

Il se pose toutefois le problème de localiser les vias qui sont invisibles depuis la face arrière du wafer. Ce problème n'est pas trivial car ces vias peuvent faire quelques micromètres ou quelques dizaines de micromètres de largeur, et il faut pouvoir positionner précisément à leur aplomb un faisceau de mesure dont le diamètre n'est pas beaucoup plus grand.

Il est connu de coupler des capteurs de mesure de distance ponctuels avec un système d'imagerie qui effectue une image de la surface du wafer, et qui permet de positionner précisément les faisceaux de mesure.

Ces systèmes ne permettent pas de résoudre ce problème de positionnement car :
- comme expliqué précédemment, les vias sont invisibles depuis la face arrière du wafer ;
- au moment où l'on effectue l'opération d'amincissement, il y a déjà des composants et des pistes métalliques qui peuvent faire plusieurs millimètres carrés sur la face des composants du wafer. Ces composants masquent complètement la position des vias, et ils sont en outre complètement opaques, ce qui interdit une localisation des vias par transparence.

Au delà de ce problème particulier, le développement des techniques de « chip level packaging » entraîne un besoin de pouvoir mesurer de manière précise des épaisseurs ou des positions de couches multiples de matériaux empilés.

Ces couches peuvent être de l'ordre du micromètre ou moins jusqu'à plusieurs centaines de micromètres, et elles peuvent être en nombre important.

On connaît aussi le document US 2005/0231713 A1 qui montre un éclairage d'un wafer de type champ noir, le document US 2012/0122252 A1, qui montre un système d'imagerie pour localiser des structures sous la surface d'un wafer, et le document US 5821549 A, qui montre un microscope infrarouge qui est aussi capable de localiser des structures sous la surface.

En pratique, aucune des méthodes de mesure citées précédemment (interférométrie ou confocal) n'est capable de satisfaire à l'ensemble des spécifications de ce type de mesure, ce qui conduit en pratique à devoir multiplier les appareils de mesure.

La présente invention a pour objet de remédier aux inconvénients de l'art antérieur en ce qui concerne les mesures de distance et d'épaisseur sur des structures complexes ;
La présente invention a notamment pour objet de proposer un système qui permette de localiser des vias ou des structures similaires invisibles depuis les faces d'un wafer ;
La présente invention a également pour objet de proposer un système qui permette d'effectuer des mesures d'épaisseur résiduelle sur des vias depuis la face arrière d'un wafer ;
La présente invention a enfin pour objet de proposer un système qui permette d'effectuer des mesures d'épaisseur dans une gamme dynamique étendue et sur un nombre élevé d'interfaces.

### Exposé de l'invention

Cet objectif est atteint avec un dispositif d'imagerie pour localiser des structures au travers de la surface d'un objet tel qu'un selon la revendication 1.

Suivant des modes de réalisation, les moyens d'illumination peuvent comprendre un filtre spectral apte à limiter le spectre du faisceau d'illumination à des longueurs d'onde qui soient aptes à essentiellement pénétrer dans l'objet.

Le filtre spectral peut comprendre :
- une lame dans un matériau identique ou similaire à un matériau de l'objet ;
- une lame en silicium ;
- une lame filtrant le spectre optique de telle sorte à ne laisser traverser que les longueurs d'ondes supérieures à une longueur d'onde de coupure ;
- une lame filtrant le spectre optique de telle sorte à ne laisser traverser que les longueurs d'ondes supérieures à un micromètre ;
- une lame de type filtre interférentiel passe-haut (en longueur d'onde).

Les moyens d'illumination peuvent comprendre en outre :
- une source de lumière apte à émettre de la lumière avec un spectre comprenant des premières longueurs d'onde aptes à être essentiellement réfléchies par la surface de l'objet et des secondes longueurs d'onde aptes à essentiellement pénétrer dans l'objet, et
- des moyens de commutation pour insérer ou retirer le filtre spectral du faisceau d'illumination.

Suivant d'autres modes de réalisation, les moyens d'illumination comprennent une source de lumière apte à émettre une lumière dont le spectre est limité à des longueurs d'onde aptes à essentiellement pénétrer dans l'objet.

Les moyens d'illumination peuvent comprendre en outre une seconde source de lumière apte à émettre une lumière dont le spectre est limité à des longueurs d'onde aptes à être essentiellement réfléchies par la surface de l'objet.

Suivant des modes de réalisation, le dispositif selon l'invention comprend :
- un faisceau d'illumination incident dans le champ de vue selon un axe d'illumination sensiblement parallèle à l'axe optique du système d'imagerie ;
- un faisceau d'illumination incident dans le champ de vue selon un axe d'illumination formant avec l'axe optique du système d'imagerie un angle supérieur à l'angle définissant l'ouverture numérique dudit système d'imagerie.

Suivant des modes de réalisation, le dispositif selon l'invention peut comprendre en outre une source de lumière en transmission disposée de telle sorte à illuminer le champ de vue en transmission, au travers de l'objet.

Le capteur d'imagerie peut comprendre un capteur de type CCD ou CMOS sur substrat de silicium.

Suivant un autre aspect de l'invention, il est proposé un système pour effectuer des mesures dimensionnelles sur un objet tel qu'un wafer, comprenant au moins un capteur optique de mesure d'épaisseur et/ou de distance, et un dispositif d'imagerie selon l'invention.

Le système selon l'invention peut comprendre en outre :
- au moins un capteur optique de mesure d'épaisseur et/ou de distance basé sur un principe d'interférométrie à faible cohérence dans le domaine temporel ;
- au moins un capteur optique de mesure d'épaisseur et/ou de distance basé sur un principe d'interférométrie à faible cohérence dans le domaine spectral, ou à balayage de fréquences optiques ;
- au moins un capteur optique de mesure d'épaisseur et/ou de distance avec un faisceau de mesure traversant l'objectif distal des moyens optiques d'imagerie ;
- au moins un capteur optique de mesure d'épaisseur et/ou de distance de type confocal chromatique.

Suivant des modes de réalisation, le système selon l'invention peut comprendre au moins deux capteurs optiques de mesure d'épaisseur et/ou de distance disposés respectivement, l'un selon une face de l'objet du côté des moyens optiques d'imagerie, et l'autre selon une face opposée dudit objet.

Suivant encore un autre aspect de l'invention, il est proposé un procédé pour mesurer l'épaisseur résiduelle de matière entre une face d'un wafer et des structures telles que des vias, comprenant des étapes de :
- localisation desdites structures au travers de ladite face du wafer au moyen d'un dispositif d'imagerie selon l'invention,
- positionnement d'un capteur optique de mesure d'épaisseur et/ou de distance en regard de ladite structure, et
- mesure de l'épaisseur résiduelle de matière.

### Description des figures et modes de réalisation

D'autres avantages et particularités de l'invention apparaîtront à la lecture de la description détaillée de mises en oeuvre et de modes de réalisation nullement limitatifs, et des dessins annexés suivants :
- la figure 1 illustre un mode de réalisation d'un système de mesure selon l'invention,
- la figure 2 illustre des exemples de problématiques de mesure résolues par le système de mesure de la figure 1,
- la figure 3 illustre le schéma de principe d'un capteur de mesure basé sur l'interférométrie à faible cohérence dans le domaine temporel.

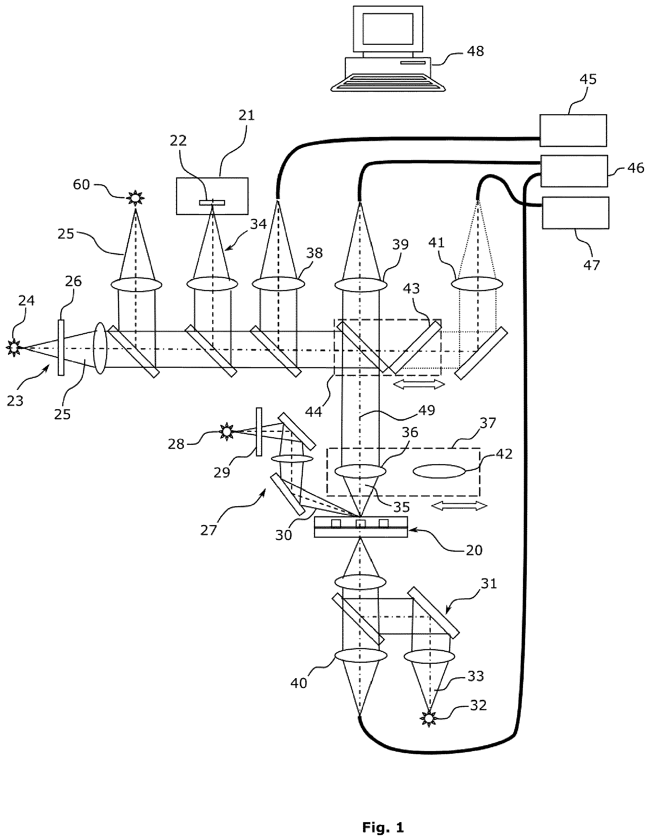

En référence à la figure 1, le système de mesure selon l'invention permet d'effectuer des mesures dimensionnelles, dont des mesures d'épaisseur, sur un objet de mesure 20.

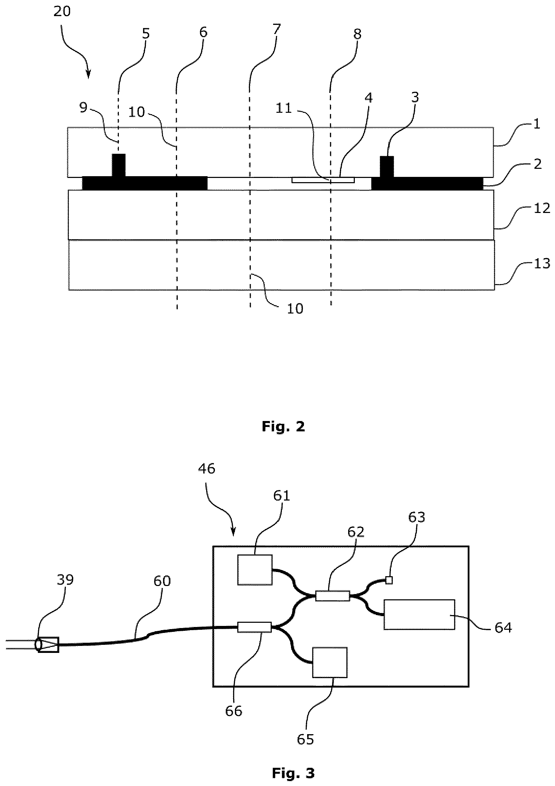

La figure 2 présente un exemple d'objet de mesure 20 qui est constitué d'un assemblage de couches de matériaux 1, 12, 13 avec des composants et des pistes 2 présents sur certaines interfaces.

Cet exemple est purement illustratif et n'a pas pour but de représenter fidèlement une étape particulière dans un processus de fabrication de composants. Il illustre simplement de manière non limitative un ensemble de problématiques de mesure qui peuvent être rencontrées, pas nécessairement simultanément, au cours d'un processus de fabrication de composants en micro-optique, microsystèmes ou microélectronique, et plus particulièrement lorsque des techniques d'assemblage de composants en 3 dimensions, ou des techniques de type « chip level packaging » sont mises en oeuvre.

Il est bien entendu que le système de mesure selon l'invention peut être mis en oeuvre sur des objets de mesure 20 avec tout type de matériaux compatibles avec les techniques et les longueurs d'onde de mesure employées, moyennant des adaptations de routine à la portée de l'homme du métier.

Ces matériaux peuvent comprendre notamment du silicium (Si), des composés III-V tels que de l'arséniure de gallium (GaAs) ou du phosphure d'indium (InP), du carbure de silicium (SiC), du verre de saphir, de la silice, du silicium sur isolant (SOI), ... sous forme de wafers (galettes de matériau), de couches déposées, etc.

L'objet de mesure 20 présenté dans l'exemple de la figure 2 comprend un wafer 1 en silicium, dans lequel ont été gravés des vias 3. Ces vias 3 (ou « Through Silicon Vias », TSV) correspondent à des structures en creux, telles que des tranchées ou des trous, d'une largeur de quelques micromètres à plusieurs dizaines de micromètres.

Les vias 3 sont par exemple destinés à réaliser des interconnexions entre des composants ou des pistes métalliques 2 et d'autres composants ajoutés dans une étape ultérieure du processus sur la face externe du wafer 1. Dans ce cas ils sont métallisés.

Pour pouvoir réaliser ces interconnexions, il est nécessaire d'amincir le wafer 1 pour rendre les vias 3 apparents sur sa face externe. Cette opération d'amincissement est usuellement réalisée par polissage de la face externe du wafer 1. Elle nécessite un contrôle régulier et précis de l'épaisseur résiduelle 9 entre les vias et la face externe du wafer 1 au cours du processus. Cette mesure est une mesure dite de RST (« Remaining Silicon Thickness »)

Pour pouvoir effectuer cette mesure, il faut pouvoir localiser les vias 3 au travers de la surface du wafer 1 et positionner précisément le faisceau de mesure d'un capteur de distance ou d'épaisseur sur l'axe de mesure 5. En outre, les vias 3 ne peuvent pas être localisés par transparence car ils sont à l'aplomb de composants opaques 2 de bien plus grande dimension.

Comme l'illustre la figure 2, d'autres problématiques de mesures sont avantageusement résolues avec le système selon l'invention :
- selon l'axe de mesure 6, la mesure d'épaisseur 10 de structures empilées (ou la localisation des interfaces) lorsque des composants 2 opaques se trouvent sur le trajet des faisceaux de mesure ;
- selon l'axe de mesure 7, la mesure des épaisseurs 10 d'un grand nombre de couches successives, avec la localisation des interfaces,
- selon l'axe de mesure 8, des mesures d'épaisseur dans une grande gamme dynamique, sur des couches de matériau 11 de l'ordre du micromètre jusqu'à des épaisseurs de matériau 10 de plusieurs centaines de micromètres, avec la localisation des interfaces.

Nous allons maintenant décrire le système de mesure de la figure 1, et la façon dont il permet d'effectuer les mesures de la figure 2.

Le système de mesure selon l'invention comprend :
- des capteurs de mesure de distance ou d'épaisseur optiques ponctuels, qui permettent l'acquisition de mesures selon des axes de mesure 5, 6, 7, 8,
- un dispositif d'imagerie pour visualiser l'objet 20 et pouvoir positionner les capteurs de mesure relativement à cet objet,
- un support d'échantillon destiné à recevoir l'objet de mesure 20, avec un système de positionnement mécanique pour le déplacer relativement au dispositif d'imagerie et aux capteurs de mesure.

### Dispositif d'imagerie

Le dispositif d'imagerie comprend une caméra 21, avec un capteur matriciel 22 de type CCD ou CMOS.

Un ensemble de moyens optiques d'imagerie 34, constitués pour l'essentiel de lentilles et d'éléments séparateurs ou combinateurs de faisceaux (lames séparatrices, miroirs partiellement transparents, cubes), permet d'imager l'objet 20 selon un champ de vue sur le capteur 22 de la caméra 21.

Ces moyens optiques d'imagerie 34 comprennent en particulier une optique distale 36, qui permet d'ajuster le grandissement de l'image. Cette optique distale comprend un objectif de microscope monté sur une tourelle porte-objectifs 37 pour pouvoir être facilement changé.

Le dispositif d'imagerie comprend également des moyens d'illumination pour éclairer le champ de vue sur l'objet 20.

Le dispositif d'imagerie doit permettre :
- de visualiser la surface de l'objet 20, pour permettre son inspection ou localiser des capteurs de mesure par rapport à des structures qui peuvent y être présentes,
- de localiser des structures telles que des composants 2, enterrées dans l'objet 20, dans des cas où elles peuvent être visibles par transparence, par exemple pour effectuer des mesures entre ces structures 2 selon l'axe de mesure 7 de l'exemple de la figure 2,
- et également de localiser des structures telles que des vias 3, enterrées dans l'objet 20, dans des cas où elles ne sont pas visibles par transparence, par exemple pour effectuer des mesures sur ces structures 3 selon l'axe de mesure 5 de l'exemple de la figure 2.

En outre, il peut être utile de pouvoir détecter à la fois les composants 2 et les vias 3, par exemple pour identifier les vias 3 relativement aux composants 2.

La nécessité de pouvoir visualiser à la fois la surface de l'objet 20 et des structures enterrées 3 non-visibles en transparence entraîne des contraintes contradictoires : Il faut dans un cas pouvoir imager la surface dans de bonnes conditions et dans l'autre cas pouvoir imager des structures 3 qui sont parfois juste à quelques micromètres de profondeur sous cette surface, sans être gêné par les réflexions de la surface.

Ces problèmes sont résolus dans l'invention grâce aux configurations d'éclairage mises en oeuvre.

Le silicium est un matériau qui est opaque dans la partie visible du spectre optique, et qui devient transparent pour des longueurs d'onde dans le proche infrarouge, au delà de 1 micromètre.

De manière intéressante, on trouve des caméras 21 à base de capteurs 22 CCD ou CMOS sur substrat de silicium qui ont une sensibilité qui s'étend jusqu'à des longueurs d'ondes de 1.1 µm. Ces caméras ont l'avantage, par rapport aux caméras infrarouge, de rester des caméras industrielles classiques de coût modéré.

Il est donc possible de faire de l'imagerie au travers du silicium avec de telles caméras, et un éclairage adapté. Toutefois, leur sensibilité pour des longueurs d'onde au delà de 1 µm est médiocre, et sans précaution particulière les mesures sont rendues impossibles par la réflectivité des surfaces de l'objet 20.

Le dispositif d'imagerie selon l'invention comprend une première voie d'éclairage 23 destinée à produire un éclairage en réflexion de type champ clair (« brightfield »). Cet éclairage produit un faisceau d'illumination 25 qui est incident sur l'objet 20 selon un axe d'illumination sensiblement parallèle à l'axe optique 49 du système d'imagerie. La lumière réfléchie ou diffusée sur toutes les surfaces sensiblement perpendiculaires à l'axe optique 49 contribue à l'image sur la caméra 21.

La première voie d'éclairage 23 comprend une source de lumière 24.

Dans le mode de réalisation présenté, cette source de lumière 24 comprend une lampe halogène reliée au système optique par un faisceau de fibres optiques. Cette source de lumière 24 émet de la lumière dans des longueurs d'ondes visibles et proche infrarouge.

La première voie d'éclairage 23 comprend en outre un filtre spectral 26 inséré dans le faisceau d'illumination 25. Ce filtre spectral a pour fonction de limiter le spectre du faisceau d'illumination 25 incident sur l'objet 20 de telle sorte qu'il ne comporte pour l'essentiel que des longueurs d'onde qui peuvent pénétrer ou être transmises dans l'objet 20 (c'est-à-dire pour lesquelles l'objet 20 est sensiblement transparent). Dans le cas présent, avec un objet 20 en silicium, il s'agit de longueurs d'onde de l'ordre de 1 µm ou au delà.

Le filtre spectral 26 permet ainsi de minimiser les réflexions sur la surface externe de l'objet 20 dues aux longueurs d'onde de la source 24 qui ne peuvent pas pénétrer dans l'objet 20 et qui seraient donc, sans le filtre 26, essentiellement réfléchies par cette surface.

Le fait d'éliminer ou au moins d'atténuer fortement ces réflexions qui autrement satureraient l'image de la caméra 21 permet d'obtenir une image des structures (telles que des vias 3) situées sous la surface de l'objet 20 avec une qualité suffisante pour pouvoir les localiser.

Avantageusement, le filtre spectral 26 est constitué d'une lame mince du même matériau que l'objet 20, soit, dans le mode de réalisation présenté, du silicium.

Ainsi, il peut être réalisé d'une manière peu onéreuse, tout en présentant des caractéristiques spectrales parfaitement adaptées au matériau de l'objet 20 puisque les longueurs d'onde transmises au travers du filtre 26 sont également celles qui sont le mieux transmises au travers de la surface de l'objet 20.

La première voie d'éclairage 23 comprend également une seconde source de lumière 60 qui permet de générer un faisceau d'illumination 25 avec des longueurs d'onde pour lesquelles la réflectivité de la surface de l'objet 20 est élevée (ici les longueurs d'onde visibles), sans traverser le filtre spectral 26. Dans le mode de réalisation présenté, cette seconde source de lumière comprend une diode électroluminescente. La source de lumière 24 et la seconde source de lumière 60 sont commutées électriquement.

Le dispositif d'imagerie selon l'invention comprend une seconde voie d'éclairage 27 destinée à produire un éclairage en réflexion de type champ noir (« darkfield »). Cet éclairage produit un faisceau d'illumination 30 qui est incident sur l'objet 20 selon un axe d'illumination qui forme avec l'axe optique 49 du système d'imagerie un angle supérieur à l'angle 35 définissant l'ouverture numérique du système d'imagerie (c'est-à-dire l'angle 35 entre l'axe optique 49 du système d'imagerie et le rayon le plus écarté de l'axe optique 49 qui entre dans l'optique distale 36). Dans cette configuration, seule la lumière diffusée (sur la surface ou dans l'objet 20) en direction du système optique d'imagerie contribue à l'image sur la caméra 21.

Dans le mode de réalisation de la figure 1, l'angle entre l'axe du faisceau d'illumination 30 en champ noir et l'axe optique 49 du système d'imagerie est de l'ordre de 60 degrés, ce qui permet de couvrir les angles d'environ 50 degrés à 70 degrés.

La seconde voie d'éclairage 27 comprend une source de lumière 28.

Dans le mode de réalisation présenté, cette source de lumière 28 comprend une lampe halogène reliée au système optique par un faisceau de fibres optiques. Cette source de lumière 28 émet de la lumière dans des longueurs d'ondes visibles et proche infrarouge.

La seconde voie d'éclairage 27 comprend en outre un filtre spectral 29 inséré dans le faisceau d'illumination 30. Ce filtre spectral a pour fonction de limiter le spectre du faisceau d'illumination 30 incident sur l'objet 20 de telle sorte qu'il ne comporte pour l'essentiel que des longueurs d'onde qui peuvent pénétrer ou être transmises dans l'objet 20 (c'est-à-dire pour lesquelles l'objet 20 est sensiblement transparent). Dans le cas présent avec un objet 20 en silicium il s'agit de longueurs d'onde de l'ordre de 1 µm ou au delà.

Le filtre spectral 29 permet ainsi de minimiser les réflexions sur la surface externe de l'objet 20 dues aux longueurs d'ondes de la source 28 qui ne peuvent pas pénétrer dans l'objet 20 et qui seraient donc, sans le filtre 29, essentiellement réfléchies par cette surface.

Le fait d'éliminer ou au moins d'atténuer fortement ces réflexions qui autrement satureraient l'image de la caméra 21 permet d'obtenir une image des structures (telles que des vias 3) situées sous la surface de l'objet 20 avec une qualité suffisante pour pouvoir les localiser.

Avantageusement, le filtre spectral 29 est constitué d'une lame mince du même matériau que l'objet 20, soit, dans le mode de réalisation présenté, du silicium.

Ainsi, il peut être réalisé d'une manière peu onéreuse, tout en présentant des caractéristiques spectrales parfaitement adaptées au matériau de l'objet 20 puisque les longueurs d'onde transmises au travers du filtre 29 sont également celles qui sont le mieux transmises au travers de la surface de l'objet 20.

Le dispositif d'imagerie selon l'invention comprend une troisième voie d'éclairage 31 destinée à produire un éclairage en transmission. Cet éclairage produit un faisceau d'illumination 33 qui est incident sur l'objet 20 selon sa face opposée au système d'imagerie. La lumière transmise au travers de l'objet 20 contribue à l'image sur la caméra 21, et permet ainsi de visualiser des structures 2 de l'objet 20 qui sont visibles en transparence.

La troisième voie d'éclairage 23 comprend une source de lumière 32.

Dans le mode de réalisation présenté, cette source de lumière 32 comprend une lampe halogène reliée au système optique par un faisceau de fibres optiques. Cette source de lumière 32 émet notamment de la lumière dans des longueurs d'onde proche infrarouge, aptes à traverser l'objet 20.

Il n'y a pas de problème de réflectivité parasite dans cette configuration d'éclairage puisque les réflexions sur les surfaces de l'objet 20 ne peuvent pas être captées par les moyens d'imagerie.

Le système est conçu de telle sorte que les première, seconde et troisième voies d'éclairage puisse être utilisées de manière simultanée, ou séparément, pour obtenir des images permettant de localiser des structures dans une grande variété de situations.

Les sources de lumière 24, 28 et 32 sont ajustables en intensité.

Les filtres spectraux 26, 29 peuvent être aisément changés pour être adaptés aux matériaux de l'objet 20.

L'éclairage en champ noir de la seconde voie d'éclairage 27 permet dans certains cas de mieux localiser des structures 3, notamment dans le cas où elles seraient difficilement discernables du fond clair généré par la première voie d'éclairage 23.

Il est à noter que dans la mesure où le système selon l'invention est destiné à effectuer des mesures sur des structures complexes dans un environnement de production, la possibilité de réaliser des éclairages complexes et adaptés au mieux aux besoins, de manière automatisée ou du moins avec un minimum de manipulations, est un aspect déterminant.

Par ailleurs, il n'est pas forcément prévu de mettre en oeuvre les trois voies d'éclairage dans toutes les configurations.

### Système de mesure

Comme expliqué précédemment, le système de mesure comprend le dispositif d'imagerie et des capteurs de mesure de distance ou d'épaisseur optiques ponctuels 45, 46, 47.

Ces capteurs sont interfacés avec les moyens optiques d'imagerie 34 de telle sorte que le dispositif d'imagerie permette de positionner précisément les points de mesure sur l'objet 20.

Nous allons maintenant décrire les capteurs de mesure de distance ou d'épaisseur optiques ponctuels 4 tels qu'ils sont mis en oeuvre dans le mode de réalisation de la figure 1.

Le système selon l'invention comprend un capteur 46 qui fonctionne selon un principe d'interférométrie à faible cohérence dans le domaine temporel. Cette technique est appelée également « Time-Domain Optical Coherence Tomography » en anglais, ou TD-OCT.

La figure 3 présente un schéma de principe d'un tel capteur TD-OCT 46, basé sur une architecture d'interféromètre à fibres optiques.

Le capteur TD-OCT 46 comprend une source de lumière 61 (telle qu'une diode super-luminescente fibrée) qui émet une lumière polychromatique dans l'infrarouge proche (par exemple autour de 1310 nm), de telle sorte à pouvoir pénétrer les couches de l'objet 20.

La lumière de la source est séparée en deux composantes par un coupleur à fibres 62. Ces deux composantes sont réfléchies respectivement par une ligne à retard 64 et une référence interne 63 de telle sorte à introduite un retard optique entre elles. Les réflexions sont recombinées par le coupleur 62, et dirigées vers un collimateur de mesure 39 et l'objet à mesurer 20 au travers du coupleur 66 et d'une fibre optique 60. Une réflexion supplémentaire est générée au niveau du collimateur de mesure 39 sur une surface de référence.

La lumière réfléchie par un objet de mesure 20 et collectée en retour par le collimateur de mesure 39, ainsi que la réflexion sur la surface de référence dans le collimateur 39, sont dirigées au travers du coupleur 66 vers un détecteur 65.

Un balayage temporel est effectué par la ligne à retard 64. A chaque fois que le retard optique entre la référence dans le collimateur 39 et une réflexion sur une interface de l'objet 20 est reproduit entre la référence interne 63 et la ligne à retard 64, on obtient un pic d'interférence sur le signal du détecteur 65.

On obtient ainsi un signal dans lequel la position des pics d'interférence en fonction du retard introduit dans la ligne à retard est directement représentative de la succession ou de la position des interfaces de l'objet 20 sur lesquelles les réflexions ont eu lieu.

On peut ainsi imager des structures de couches complexes, par exemple le long de l'axe de mesure 10 de la figure 2, et obtenir la succession de toutes les couches ou de toutes les interfaces.

Avantageusement, le faisceau de mesure issu du collimateur de mesure 39 est inséré dans les moyens optiques d'imagerie 34, dont il traverse en particulier l'objectif distal 36. Ainsi, il est possible d'effectuer des mesures tout en observant l'objet avec la caméra 21.

Le capteur TD-OCT 46 comprend une seconde voie de mesure, avec une optique de collimation 40, qui permet d'effectuer également des mesures par la face opposée de l'objet 20 relativement au système d'imagerie.

Cela permet de mesurer par exemple des successions de couches de l'objet 20 de part et d'autre d'une structure opaque 2, par exemple selon l'axe de mesure 6.

Dans la mesure où le capteur TD-OCT 46 fournit des mesures de distances optiques absolues relativement à la référence dans les collimateurs 39 ou 40, cette configuration de mesure dite « en étrier » permet également d'effectuer des mesures d'épaisseur sur des structures 2 opaques, avec une calibration adéquate des deux voies de mesure 39, 40.

Un inconvénient du capteur TD-OCT 46 est qu'il ne permet pas de distinguer des interfaces séparées de moins de quelques micromètres. Cette limitation provient du fait que la largeur des pics d'interférence est une fonction inverse de la largeur spectrale de la source 61, et la largeur spectrale des sources disponibles commercialement et de coût raisonnable est limitée.

Avantageusement, le système selon l'invention comprend également un capteur 45 qui fonctionne selon un principe d'interférométrie à faible cohérence dans le domaine fréquentiel ou spectral. Cette technique est appelée également « Frequency Domain Optical Coherence Tomography » en anglais, ou FD-OCT.

Le capteur FD-OCT 45 comprend une source de lumière qui émet une lumière polychromatique dans l'infrarouge proche, de telle sorte à pouvoir pénétrer les couches de l'objet 20. Alternativement, il peut mettre en oeuvre une source accordable en longueur d'onde dont on fait varier la longueur d'onde au cours du temps de sorte à balayer le spectre utile.

Le faisceau de mesure du capteur FD-OCT 45 est inséré au moyen d'un collimateur 38 dans les moyens optiques d'imagerie 34, dont il traverse en particulier l'objectif distal 36. Ainsi, il est possible d'effectuer des mesures tout en observant l'objet avec la caméra 21.

La lumière réfléchie par l'objet 20 est analysée dans le capteur FD-OCT 45 par un spectromètre optique.

On obtient ainsi un spectre dont les ondulations sont représentatives des épaisseurs des couches traversées par le faisceau de mesure du capteur FD-OCT 45. Ces ondulations sont dues aux interférences constructrices ou destructrices qui apparaissent aux différentes longueurs d'onde, en fonction des distances optiques entre les réflexions.

Cette méthode a l'avantage de permettre la mesure de petites épaisseurs, jusqu'à un micromètre ou moins suivant la largeur spectrale de la source.

Son principal inconvénient est que la succession spatiale des couches de l'objet 20 n'est pas conservée dans les mesures : on obtient des mesures d'épaisseur dont on ne peut pas déterminer l'ordre ou la séquence, ce qui rend l'interprétation des mesures difficile pour un objet complexe 20.

En outre, l'épaisseur maximale mesurable avec un capteur FD-OCT dépend de la résolution du spectromètre, et donc du nombre de détecteurs individuels qu'il comprend. Ce nombre de détecteurs est limité dans les spectromètres actuels qui utilisent des capteurs proche-infrarouge en technologie InGaAs ou des multi-puits quantiques. Il s'ensuit que l'épaisseur maximale mesurable avec un capteur FD-OCT est plus limitée qu'avec la technique TD-OCT dans laquelle elle est déterminée par le retard maximal qui peut être introduit par la ligne à retard 64.

Suivant un aspect avantageux de l'invention qui la distingue des dispositifs de l'art antérieur, les capteurs TD-OCT 46 et FD-OCT 45 sont utilisés de manière combinée. Cela permet par exemple d'effectuer les mesures du type de celle de l'axe de mesure 8 de la figure 2.

Dans cet exemple, une couche transparente 4 d'une épaisseur de l'ordre d'un micromètre est déposée sur la face composant.

Le capteur TD-OCT 46 fournit la succession des couches 10, mais le dépôt 4 est trop mince pour que son épaisseur puisse être mesurée : Il apparaît sous la forme d'un pic unique dans le signal de mesure du capteur TD-OCT 46.

Avantageusement, la mesure complémentaire effectuée par le capteur FD-OCT 45 permet de mesurer cette épaisseur. Ainsi, en combinant les mesures des capteurs TD-OCT 46 et FD-OCT 45, on obtient une représentation des couches selon l'axe de mesure 8 qui ne serait pas réalisable avec seulement l'un des deux capteurs.

Le système selon l'invention comprend également un capteur de distance de type confocal chromatique 47.

Le capteur confocal chromatique 47 est mis en oeuvre avec une optique chromatique constituée d'un élément dispersif 41 et d'un collimateur 42. Ces éléments sont conçus de telle sorte que les différentes longueurs d'onde de la lumière issue du capteur confocal chromatique 47 qui les traverse sont focalisées à des distances différentes au niveau de l'objet 20. Les réflexions sur l'objet 20 sont collectées par ces optiques chromatiques 41, 42, et transmises à un spectromètre dans le capteur confocal chromatique 47. L'analyse des maxima du spectre permet de mesurer la position des interfaces de l'objet 20 à l'origine de ces réflexions.

Le collimateur 42 est monté sur la tourelle porte-objectifs 37. L'élément dispersif 41 est intégré dans le système optique au moyen d'un chariot mobile 44 qui déplace un miroir de renvoi 43. La mesure avec le capteur confocal chromatique 47 ne peut pas être effectuée en même temps que les autres mesures, mais les éléments sont ajustés de telle sorte que l'axe optique des optiques chromatiques 41, 42 soit confondu avec l'axe optique 49 du système d'imagerie, afin de pouvoir effectuer des mesures avec le capteur confocal chromatique 47 en des positions précisément localisées au préalable avec le système d'imagerie.

Le capteur confocal chromatique 47 a l'avantage de permettre des mesures de distances absolues à une grande cadence, ce qui n'est pas réalisable avec le capteur FD-OCT 45 ou avec le capteur TD-OCT 46.

Ainsi, les trois types de capteurs mis en oeuvre dans l'invention (TD-OCT 46, FD-OCT 45 et confocal chromatique 47) sont fortement complémentaires et permettent d'effectuer des mesures suivant un grand nombre de configurations sur l'objet 20.

L'ensemble du système est contrôlé au moyen d'un ordinateur 48 et d'un logiciel d'exploitation, qui permettent d'une part d'ajuster au mieux les voies d'éclairage en champ clair 23, en champ noir 27 et en transmission 31, et d'autre part de réaliser des mesures en combinant de manière optimale les capteurs TD-OCT 46, FD-OCT 45 et confocal chromatique 47.

Ainsi, des protocoles de mesure complexes peuvent être réalisés de manière semi-automatisée, à partir de « recettes » préprogrammées, avec un minimum de manipulations de la part de l'opérateur.

Les mesures peuvent également être automatisées, en mettent en oeuvre une connaissance *a priori* de l'objet 20, et/ou des techniques d'analyse d'image.

Suivant des variantes de modes de réalisation, l'éclairage en champ noir (« darkfield ») peut être réalisé sous la forme d'un éclairage annulaire.

Suivant des variantes de modes de réalisation, les filtres spectraux 26, 29 des première et seconde voies d'éclairage peuvent être réalisés de toute autre manière permettant d'obtenir des caractéristiques spectrales adaptées. Ils peuvent comprendre notamment :
- une superposition de couches de matériaux diélectriques pour réaliser un filtre interférentiel,
- un matériau différent de ceux de l'objet 20 mais présentant des caractéristiques spectrales adaptées.

Suivant des variantes de modes de réalisation :
- Le filtre spectral 26 de la première voie d'éclairage 23 peut être monté sur un support amovible qui permet de le retirer du faisceau d'illumination 25. De même, le filtre spectral 29 de la seconde voie d'éclairage 27 peut être monté sur un support amovible qui permet de le retirer du faisceau d'illumination 30. Cela permet de pouvoir imager la surface de l'objet 20 dans les meilleures conditions, c'est-à-dire en exploitant les longueurs d'onde de la lumière de la source 24 et/ou de la source de lumière 28 pour lesquelles la réflectivité de la surface de l'objet 20 est élevée (ici les longueurs d'onde visibles) ;
- La première voie d'éclairage 23 peut ne pas comprendre de seconde source de lumière 60 ;
- La seconde voie d'éclairage 27 peut comprendre en outre une seconde source de lumière qui permette de générer un faisceau d'illumination 30 avec des longueurs d'onde pour lesquelles la réflectivité de la surface de l'objet 20 est élevée (ici les longueurs d'onde visibles), sans traverser le filtre spectral 29 ;
- Des sources de lumières 24, 60, 28, et/ou 32 peuvent être générées à partir d'une ou de plusieurs sources de lumière primaires partagées entre des voies d'éclairage 23, 27, 31, simultanément ou séquentiellement. Cela peut notamment être réalisé avec des faisceaux de fibres adaptés qui convoient la lumière de la ou des source(s) primaire(s) vers le système optique ;
- Les sources de lumières 24, 60, 28, et/ou 32 peuvent comprendre toute source de lumière adaptée, telle que par exemple des lampes à décharge ou des lampes au xénon fibrées ;
- Les sources de lumière 24, 28, et/ou 32 peuvent comprendre des sources de lumière avec un spectre d'émission limité à des longueurs d'onde capables de pénétrer dans l'objet 20, telles que par exemple des diodes électroluminescentes avec un spectre d'émission centré autour de 1050 nm. Dans ce cas, le dispositif selon l'invention peut ne pas comprendre de filtre spectral 26, 29 dans la première et/ou la seconde voie d'éclairage 23, 27.

Suivant des variantes de modes de réalisation, d'autres configurations de capteurs que celle présentée à la figure 1 peuvent être envisagées, en fonction des applications. Ces capteurs peuvent être basés sur d'autres technologies, et/ou mesurer d'autres grandeurs que des distances et des épaisseurs.

Le dispositif d'imagerie peut également être complété par un interféromètre à faible cohérence à plein champ, pour effectuer des mesures de topologie sur l'objet 20. Cet interféromètre peut être constitué au niveau de l'objectif distal 36, de telle sorte à obtenir sur la caméra 21 des franges d'interférence représentatives des altitudes de l'objet 20. Il peut être constitué par exemple en intercalant une lame semi-réfléchissante entre l'objectif distal 36 et l'objet 20, et un miroir de référence entre cette lame semi-réfléchissante et l'objectif distal 36. Des mesures de topologie de l'objet 20 peuvent ainsi être obtenues en effectuant un déplacement contrôlé de cet objet 20 relativement au système optique de telle sorte à balayer toutes les altitudes utiles.

Bien sûr, l'invention n'est pas limitée aux exemples qui viennent d'être décrits et de nombreux aménagements peuvent être apportés à ces exemples sans sortir du cadre de l'invention.

## Revendications

1. Dispositif d'imagerie pour localiser des structures (2, 3) au travers de la surface d'un objet (20) tel qu'un wafer, en vue de positionner un capteur de mesure (45, 46, 47) relativement aux dites structures (2, 3), comprenant :
- un capteur d'imagerie (22),
- des moyens optiques d'imagerie (34) aptes à produire sur ledit capteur d'imagerie (22) une image de l'objet (20) selon un champ de vue,
- des moyens d'illumination (23, 27) pour générer un faisceau d'illumination (25, 30) et éclairer ledit champ de vue en réflexion,
**caractérisé en ce que** les moyens d'illumination (23, 27) :
- sont aptes à générer un faisceau d'illumination (25, 30) dont le contenu spectral est adapté à la nature de l'objet (20), de telle sorte que la lumière dudit faisceau (25, 30) soit apte à essentiellement pénétrer dans ledit objet (20),
- sont aptes à produire un éclairage de type « champ clair » avec un faisceau d'illumination (25) qui est incident dans le champ de vue selon un axe substantiellement parallèle à l'axe optique (49) du système d'imagerie, de sorte que la lumière réfléchie ou diffusée en direction du système d'imagerie sur toutes les surfaces sensiblement perpendiculaires à l'axe optique (49) contribue à l'image, et
- sont aptes à produire un éclairage de type « champ noir » avec un faisceau d'illumination (30) qui est incident dans le champ de vue selon un axe d'illumination formant avec l'axe optique (49) du système d'imagerie un angle supérieur à l'angle (35) définissant l'ouverture numérique dudit système d'imagerie, de sorte que seule la lumière diffusée sur ou dans l'objet (20) en direction du système optiques d'imagerie contribue à l'image.

2. Le dispositif de la revendication 1, dans lequel les moyens d'illumination (23, 27) comprennent un filtre spectral (26, 29) apte à limiter le spectre du faisceau d'illumination à des longueurs d'onde qui soient aptes à essentiellement pénétrer dans l'objet (20).

3. Le dispositif de la revendication 2, dans lequel le filtre spectral (26, 29) comprend une lame dans un matériau identique ou similaire à un matériau de l'objet (20).

4. Le dispositif de l'une des revendications 2 ou 3, dans lequel le filtre spectral (26, 29) comprend une lame en silicium.

5. Le dispositif de l'une des revendications 2 à 4, dans lequel les moyens d'illumination (23, 27) comprennent en outre :
- une source de lumière (24, 28) apte à émettre de la lumière avec un spectre comprenant des premières longueurs d'onde aptes à être essentiellement réfléchies par la surface de l'objet (20) et des secondes longueurs d'onde aptes à essentiellement pénétrer dans l'objet (20), et
- des moyens de commutation pour insérer ou retirer le filtre spectral (26, 29) du faisceau d'illumination.

6. Le dispositif de la revendication 1, dans lequel les moyens d'illumination (23, 27) comprennent une source de lumière apte à émettre une lumière dont le spectre est limité à des longueurs d'onde aptes à essentiellement pénétrer dans l'objet (20).

7. Le dispositif de la revendication 6, dans lequel les moyens d'illumination (23, 27) comprennent en outre une seconde source de lumière apte à émettre une lumière dont le spectre est limité à des longueurs d'onde aptes à être essentiellement réfléchies par la surface de l'objet (20).

8. Le dispositif de l'une des revendications précédentes, qui comprend en outre une source de lumière en transmission (32) disposée de telle sorte à illuminer le champ de vue en transmission, au travers de l'objet (20).

9. Le dispositif de l'une des revendications précédentes, dans lequel le capteur d'imagerie (22) comprend un capteur de type CCD ou CMOS sur substrat de silicium.

10. Système pour effectuer des mesures dimensionnelles sur un objet (20) tel qu'un wafer, **caractérisé en ce qu'**il comprend au moins un capteur optique de mesure d'épaisseur et/ou de distance (45, 46, 47), et un dispositif d'imagerie selon l'une quelconque des revendications précédentes.

11. Le système de la revendication 10, qui comprend en outre au moins un capteur optique de mesure d'épaisseur et/ou de distance (46) basé sur un principe d'interférométrie à faible cohérence dans le domaine temporel.

12. Le système de l'une des revendications 10 ou 11, qui comprend en outre au moins un capteur optique de mesure d'épaisseur et/ou de distance (45) basé sur un principe d'interférométrie à faible cohérence dans le domaine spectral, ou à balayage de fréquences optiques.

13. Le système de l'une des revendications 10 à 12, qui comprend au moins un capteur optique de mesure d'épaisseur et/ou de distance (45, 46) avec un faisceau de mesure traversant l'objectif distal (36) des moyens optiques d'imagerie.

14. Le système de l'une des revendications 10 à 13, qui comprend en outre au moins un capteur optique de mesure d'épaisseur et/ou de distance (47) de type confocal chromatique.

15. Le système de l'une des revendications 10 à 14, qui comprend au moins deux capteurs optiques de mesure d'épaisseur et/ou de distance (45, 46, 47) disposés respectivement, l'un selon une face de l'objet du côté des moyens optiques d'imagerie, et l'autre selon une face opposée dudit objet (20).

16. Procédé pour mesurer l'épaisseur résiduelle de matière (9) entre une face d'un wafer (20) et des structures (3) telles que des vias, **caractérisé en ce qu'**il comprend des étapes de :
- localisation desdites structures (3) au travers de ladite face du wafer (20) au moyen d'un dispositif d'imagerie selon l'une des revendications 1 à 10,
- positionnement d'un capteur optique de mesure d'épaisseur et/ou de distance (45, 46, 47) en regard de ladite structure (3), et
- mesure de l'épaisseur résiduelle de matière (9).

## Patentansprüche

1. Bildgebungsvorrichtung zur Lokalisierung von Strukturen (2, 3) durch die Oberfläche eines Gegenstands (20) wie zum Beispiel eines Wafers hindurch, um einen Messaufnehmer (45, 46, 47) bezüglich der Strukturen (2, 3) zu positionieren, umfassend:
- einen Bildgebungssensor (22),
- optische Bildgebungsmittel (34), die zur Bildgebung des Gegenstands (20) auf dem Bildgebungssensor (22) gemäß eines Bildbereichs geeignet sind;
- Beleuchtungsmittel (23, 27) zur Erzeugung eines Beleuchtungsstrahls (25, 30) und zur reflexionsartigen Beleuchtung des Bildbereichs,
**dadurch gekennzeichnet, dass** die Beleuchtungsmittel (23, 27):
- zur Erzeugung eines Beleuchtungsstrahls (25, 30) geeignet sind, dessen spektraler Inhalt an die Beschaffenheit des Gegenstands (20) derart angepasst ist, dass das Licht des Strahls (25, 30) dazu geeignet ist, im Wesentlichen in den Gegenstand (20) hineinzudringen,
- geeignet sind, eine Beleuchtung vom Typ "Hellfeld" mit einem Beleuchtungsstrahl (25) herzustellen, der in den Bildbereich entlang einer weitgehend parallel zu der optischen Achse (49) des Bildgebungssystems verlaufenden Achse einfällt, sodass das in Richtung des Bildgebungssystems auf allen im Wesentlichen senkrecht zur optischen Achse (49) verlaufenden Oberflächen reflektierte oder gestreute Licht zur Bildgebung beiträgt, und
- geeignet sind, eine Beleuchtung vom Typ "Dunkelfeld" mit einem Beleuchtungsstrahl (30) herzustellen, der in den Bildbereich entlang einer Beleuchtungsachse (30) einfällt, welche mit der optischen Achse (49) des Bildgebungssystems einen Winkel größer als der die numerische Apertur des Bildgebungssystems bestimmende Winkel (35) bildet, sodass nur das auf oder in den Gegenstand (20) in Richtung des optischen Bildgebungssystems gestreute Licht zur Bildgebung beiträgt.

2. Vorrichtung nach Anspruch 1, wobei die Beleuchtungsmittel (23, 27) ein Spektralfilter (26, 29) umfassen, das geeignet ist, das Spektrum des Beleuchtungsstrahls auf im Wesentlichen zur Eindringung in den Gegenstand (20) geeignete Wellenlängen zu begrenzen.

3. Vorrichtung nach Anspruch 2, wobei das Spektralfilter (26, 29) eine Platte aus einem gleichen oder ähnlichem Material wie ein Material des Gegenstands (20) umfasst.

4. Vorrichtung nach einem der Ansprüche 2 oder 3, wobei das Spektralfilter (26, 29) eine Siliziumplatte umfasst.

5. Vorrichtung nach einem der Ansprüche 2 bis 4, wobei die Beleuchtungsmittel (23, 27) außerdem umfassen:
- eine Lichtquelle (24, 28), zum Emittieren von Licht mit einem Spektrum geeignet, welches erste, im Wesentlichen durch die Oberfläche des Gegenstands (20) reflektierbare Wellenlängen und zweite, im Wesentlichen zur Eindringung in den Gegenstand (20) geeignete Wellenlängen umfasst, und
- Schaltmittel, um das Spektralfilter (26, 29) in den Beleuchtungsstrahl einzuführen oder aus diesem zu entnehmen.

6. Vorrichtung nach Anspruch 1, wobei die Beleuchtungsmittel (23, 27) eine Lichtquelle umfassen, die geeignet ist, Licht zu emittieren, dessen Spektrum auf im Wesentlichen zur Eindringung in den Gegenstand (20) geeignete Wellenlängen begrenzt ist.

7. Vorrichtung nach Anspruch 6, wobei die Beleuchtungsmittel (23, 27) außerdem eine zweite Lichtquelle umfassen, die geeignet ist, Licht zu emittieren, dessen Spektrum auf im Wesentlichen zur Reflexion durch die Oberfläche des Gegenstands (20) geeignete Wellenlängen begrenzt ist.

8. Vorrichtung nach einem der vorhergehenden Ansprüche, welche außerdem eine derart angeordnete Transmissionslichtquelle (32) umfasst, dass der Bildbereich per Transmission durch den Gegenstand (20) hindurch beleuchtet wird.

9. Vorrichtung nach einem der vorhergehenden Ansprüche, wobei der Bildgebungssensor (22) einen Sensor vom Typ CCD oder CMOS auf Siliziumsubstrat umfasst.

10. System zur Ausführung von dimensionellen Messungen auf einem Gegenstand (20) wie zum Beispiel einem Wafer, **dadurch gekennzeichnet, dass** es mindestens einen optischen Messaufnehmer zur Messung von Dicke und/oder Entfernung (45, 46, 47) und eine Bildgebungsvorrichtung nach einem der vorhergehenden Ansprüche umfasst.

11. System nach Anspruch 10, welches außerdem mindestens einen optischen Messaufnehmer zur Messung von Dicke und/oder Entfernung (46) auf der Grundlage eines Grundsatzes der niedrigkohärenten Interferometrie im Zeitbereich umfasst.

12. System nach einem der Ansprüche 10 oder 11, welches außerdem mindestens einen optischen Messaufnehmer zur Messung von Dicke und/oder Entfernung (45) auf der Grundlage eines Grundsatzes der niedrigkohärenten Interferometrie in spektralem Bereich oder per Abtasten von optischen Frequenzen umfasst.

13. System nach einem der Ansprüche 10 bis 12, welches mindestens einen optischen Messaufnehmer zur Messung von Dicke und/oder Entfernung (45, 46) mit einem das distalseitige Objektiv (36) der optischen Bildgebungsmittel durchdringenden Messstrahl umfasst.

14. System nach einem der Ansprüche 10 bis 13, welches außerdem mindestens einen optischen Messaufnehmer zur Messung von Dicke und/oder Entfernung (47) mit chromatisch konfokalem Aufbau umfasst.

15. System nach einem der Ansprüche 10 bis 14, das mindestens zwei optische Messaufnehmer zur Messung von Dicke und/oder Entfernung (45, 46, 47) umfasst, wobei einer entsprechend einer den optischen Bildgebungsmitteln zugewandten Seite des Gegenstands (20) und der andere entsprechend einer gegenüberliegenden Seite des Gegenstands (20) angeordnet ist.

16. Verfahren zur Messung der Materialrestdicke (9) zwischen einer Seite eines Wafers (20) und Strukturen (3) wie zum Beispiel Durchgangsverbindungen, **dadurch gekennzeichnet, dass** es die Schritte umfasst:
- der Lokalisierung dieser Strukturen (3) durch die Seite des Wafers (20) hindurch mit Hilfe einer Bildgebungsvorrichtung nach einem der Ansprüche 1 bis 10;
- der Positionierung eines optischen Messaufnehmers zur Messung von Dicke und/oder Entfernung (45, 46, 47) gegenüber der Struktur (3); und
- der Messung der Materialrestdicke (9).

## Claims

1. Imaging device for locating structures (2, 3) through the surface of an object (20) such as a wafer, in order to position a measuring sensor (45, 46, 47) relative to said structures (2, 3), comprising:
- an imaging sensor (22),
- optical imaging means (34) capable of producing, on said imaging sensor (22), an image of the object (20) in a field of view,
- illuminating means (23, 27) for generating an illuminating beam (25, 30) and lighting said field of view in reflection,
**characterized in that** the illuminating means (23, 27):
- are capable of generating an illuminating beam (25, 30) the spectral content of which is suited to the nature of the object (20), so that the light of said beam (25, 30) is capable essentially of penetrating into said object (20),
- are capable of producing a lighting of the "bright field" type with an illuminating beam (25) which is incident in the field of view along an axis substantially parallel to the optical axis (49) of the imaging system, in such a way that the light reflected or diffused in the direction of the imaging system on all the surfaces substantially perpendicular to the optical axis (49) contributes to the image, and
- are capable of producing a lighting of the "dark field" type with an illuminating beam (30) which is incident in the field of view along an axis of illumination forming with the optical axis (49) of the imaging system an angle greater than the angle (35) defining the numerical aperture of said imaging system, in such a way that only the light diffused on or in the object (20) in direction of the optical imaging system contributes to the image.

2. The device of claim 1, in which the illuminating means (23, 27) comprise a spectral filter (26, 29) capable of limiting the spectrum of the illuminating beam to wavelengths which are capable essentially of penetrating into the object (20).

3. The device of claim 2, in which the spectral filter (26, 29) comprises a plate made of a material identical or similar to a material of the object (20).

4. The device of one of claims 2 or 3, in which the spectral filter (26, 29) comprises a silicon plate.

5. The device of one of claims 2 to 4, in which the illuminating means (23, 27) also comprise:
- a light source (24, 28) capable of emitting light with a spectrum comprising first wavelengths capable essentially of being reflected by the surface of the object (20) and second wavelengths capable essentially of penetrating into the object (20), and
- switching means for inserting the spectral filter (26, 29) into, or withdrawing it from, the illuminating beam.

6. The device of claim 1, in which the illuminating means (23, 27) comprise a light source capable of emitting a light the spectrum of which is limited to wavelengths capable essentially of penetrating into the object (20).

7. The device of claim 6, in which the illuminating means (23, 27) also comprise a second light source capable of emitting a light the spectrum of which is limited to wavelengths capable essentially of being reflected by the surface of the object (20).

8. The device of one of the preceding claims, which also comprises a source of light in transmission (32) arranged so as to illuminate the field of view in transmission, through the object (20).

9. The device of one of the preceding claims, in which the imaging sensor (22) comprises a CCD- or CMOS-type sensor on a silicon substrate.

10. System for carrying out dimensional measurements on an object (20) such as a wafer, **characterized in that** it comprises at least one optical sensor for measuring thickness and/or distance (45, 46, 47), and an imaging device according to any one of the preceding claims.

11. The system of claim 10, which also comprises at least one optical sensor for measuring thickness and/or distance (46) based on a principle of time-domain low-coherence interferometry.

12. The system of one of claims 10 or 11, which also comprises at least one optical sensor for measuring thickness and/or distance (45) based on a principle of spectral-domain low-coherence interferometry, or optical frequency scanning interferometry.

13. The system of one of claims 10 to 12, which comprises at least one optical sensor for measuring thickness and/or distance (45, 46) with a measurement beam passing through the distal objective (36) of the optical imaging means.

14. The system of one of claims 10 to 13, which also comprises at least one optical sensor for measuring thickness and/or distance (47), of the chromatic confocal type.

15. The system of one of claims 10 to 14, which comprises at least two optical sensors for measuring thickness and/or distance (45, 46, 47) arranged respectively, one on a surface of the object on the side of the optical imaging means and the other on a surface opposite said object (20).

16. Method for measuring the residual thickness of material (9) between a surface of a wafer (20) and structures (3) such as vias, **characterized in that** it comprises steps of:
- locating said structures (3) through said surface of the wafer (20) by means of an imaging device according to one of claims 1 to 10,
- positioning an optical sensor for measuring thickness and/or distance (45, 46, 47) next to said structure (3), and
- measuring the residual thickness of material (9).
